# EUROPÄISCHE PATENTSCHRIFT

(11) **EP 3 486 615 B1**
(45) Veröffentlichungstag und Bekanntmachung des Hinweises auf die Patenterteilung: **17.06.2020**
(21) Anmeldenummer: 18206884.1
(22) Anmeldetag: 19.11.2018
(51) Int. Cl.: G01D 5/28

(54) **BEDIENVORRICHTUNG MIT FOKUSSIERENDEM BEDIENELEMENT**
OPERATING DEVICE WITH FOCUSSING OPERATING ELEMENT
DISPOSITIF DE FONCTIONNEMENT POURVU D'ÉLÉMENT DE FONCTIONNEMENT FOCALISANT

(30) Priorität: 21.11.2017 DE 102017127368
(43) Veröffentlichungstag der Anmeldung: 22.05.2019
(73) Patentinhaber: Valeo Schalter und Sensoren GmbH, 74321 Bietigheim-Bissingen (DE)
(72) Erfinder: Staude, Sascha, 74321 Bietigheim-Bissingen (DE); Mack, Raphael, 74321 Bietigheim-Bissingen (DE)
(74) Vertreter: Pothmann, Karsten

(56) Entgegenhaltungen:
- GB-A- 2 465 372
- US-A- 5 943 233
- US-A1- 2011 221 707

## Beschreibung

Die vorliegende Erfindung betrifft eine Bedienvorrichtung mit einem Grundelement, einer Sende-Empfangseinrichtung, die fest an dem Grundelement angeordnet ist, zum Aussenden und Empfangen von Licht, einem Bedienelement, das gegenüber dem Grundelement zwischen einer ersten Extremstellung und einer zweiten Extremstellung bewegbar ist, und einem Optikelement, das fest an dem Bedienelement angeordnet ist, zum Umlenken des Lichts der Sende-Empfangseinrichtung. Darüber hinaus betrifft die vorliegende Erfindung eine Fahrzeugbedienanordnung mit einer derartigen Bedienvorrichtung.

Die GB 2465372 A offenbart einen optischen Umformer zur Erkennung einer Verlagerung eines Elements, wobei die Verlagerung mittels einer Lichtquelle und einem Lichtsensor erkannt wird. Dabei wird von der Lichtquelle ausgesendetes Licht an dem Element reflektiert und an den Lichtsensor weitergeleitet. In Abhängigkeit der Verlagerung des Elements ändert sich die Signalspannung des Lichtsensors.

Die US 5,943,233 offenbart ein Eingabemittel mit einem optischen Sensor des Reflektionstypes, welcher eine Lichtquelle, einen Lichtsensor und einen Betätigungsbereich aufweist. Der Betätigungsbereich ist schwenkbar und das Maß der Schwenkung durch den Sensor ermittelbar.

Die US 2011/0221707 A1 offenbart ein Display dessen Frontseite betätigbar ist. Dazu ist die Frontseite schwenkbar gelagert, so dass ein Teil des Hintergrundlichtes über Reflektoren einem Lichtsensor zugeführt wird. Damit kann die Betätigung der Frontseite erkannt werden.

Aus der Druckschrift US 2014/0098065 A1 sind ein Touch-Screen-System und ein entsprechendes Verfahren zur Erfassung einer Touch-Screen-Verlagerung bekannt. Eine Sendeeinrichtung strahlt Licht an die Rückseite des Touch-Screens. Dort wird das Licht reflektiert und trifft auf einen optischen Empfänger. Wird der Touch-Screen betätigt, ändert sich der Abstand der Bedienfläche zu der optischen Sendeeinrichtung und der optischen Empfangseinrichtung. Die aufgebrachte Kraft an der Bedienoberfläche kann mittels der sich ändernden Lichtintensität durch die hervorgerufene Abstandsänderung gemessen werden.

Die Druckschrift US 2015/0242056 A1 offenbart ein Gerät und ein Verfahren zur Detektion von Oberflächenscherkräften auf einer Anzeigevorrichtung. Die Anzeigevorrichtung weist ein Pixelarray mit einer Vielzahl an Pixeln, eine Vielzahl an Infrarotemittern, die Licht an eine Oberfläche der Anzeigevorrichtung emittieren, eine Vielzahl an IR-Detektoren zum Detektieren des IR-Lichts, eine deformierbare Schicht an der Oberfläche der Anzeigevorrichtung und eine Vielzahl an Reflektoren an der deformierbaren Schicht, um das IR-Licht zu den IR-Detektoren zu reflektieren, auf. Es soll eine Bewegung eines Eingabemittels auf einer Bedienoberfläche mittels der IR-Emitter und IR-Detektoren erkannt werden. Das Messprinzip beruht auf der Intensität.

Die Änderung der Entfernung eines Reflektors mithilfe optischer Reflexionslichtschranken zur Bestimmung ist also bekannt. Die Auflösung der Änderung der Entfernung ist aber nicht besonders hochwertig. Für eine Erkennung eines geschalteten Zustands oder einer Krafterkennung bei Schaltern ist jedoch eine besonders hohe Auflösung der Entfernungsänderung nötig.

Die Aufgabe der vorliegenden Erfindung besteht somit darin, eine Bedienvorrichtung auf optischer Basis bereitzustellen, bei der eine Änderung einer Stellung eines Bedienelements mit verbesserter Auflösung detektierbar ist.

Erfindungsgemäß wird diese Aufgabe durch eine Bedienvorrichtung nach Anspruch 1 gelöst. Vorteilhafte Weiterbildungen der Erfindung ergeben sich aus den Unteransprüchen.

Es wird somit eine Bedienvorrichtung mit einem Grundelement und einer Sende-Empfangseinrichtung, die fest an dem Grundelement angeordnet ist, zum Aussenden und Empfangen von Licht bereitgestellt. Eine derartige Bedienvorrichtung kann beispielsweise für einen Schalter, einen Weglängensensor, einen Touchscreen oder dergleichen verwendet werden. Die Bedienvorrichtung besitzt ein Grundelement, das beispielsweise als Träger, Gehäuse oder dergleichen ausgebildet sein kann. An dem Grundelement ist die Sende-Empfangseinrichtung, z.B. ein IR-Sende-Empfangschip, befestigt. Damit ist die Sende-Empfangseinrichtung ortsfest mit dem Grundelement verbunden. Weiterhin besitzt die Bedienvorrichtung ein Bedienelement, das gegenüber dem Grundelement zwischen einer ersten Extremstellung und einer zweiten Extremstellung bewegbar ist. Bei betriebsgemäßer Bedienung ist also vorgesehen, dass beispielsweise bei NichtBetätigung das Bedienelement die erste Extremstellung einnimmt und bei einer hinreichend starken Betätigung die zweite Extremstellung. So wird beispielsweise die Schalteroberfläche von einer Ausgangsstellung in eine Endstellung bewegt, wenn der Schalter betätigt wird. Dabei findet also eine Relativbewegung zwischen dem Bedienelement und dem Grundelement statt. In der Regel wird es sich hierbei um eine lineare Bewegung handeln.

Ein Optikelement, das fest an dem Bedienelement angeordnet ist, dient zum Umlenken des Lichts der Sende-Empfangseinrichtung. Das Optikelement kann beispielsweise das Licht des Sendeelements der Sende-Empfangseinrichtung zu deren Empfangselement reflektieren. Dabei ist das Optikelement fest mit dem Bedienelement verbunden beziehungsweise in dieses integriert. Dies bedeutet, dass das Optikelement gegenüber dem Grundelement bei dem Betätigen die gleiche Bewegung vollzieht. Diese Bewegung des Optikelements wirkt sich auch auf das Umlenken des Lichts aus.

Durch das Optikelement ist das Licht der Sende-Empfangseinrichtung im Wesentlichen in Richtung auf ein Empfangsteil der Sende-Empfangseinrichtung fokussierbar. Beispielsweise sendet das Sendeteil der Sende-Empfangseinrichtung divergentes Licht aus. Dieses divergente Licht trifft auf das Optikelement, welches das Licht auf dem Empfangsteil der Sende-Empfangseinrichtung fokussiert. Dies bedeutet, dass vorzugsweise der größte Teil des von dem Optikelement umgelenkten Lichts in mindestens einer der Extremstellungen des Bedienelements auf den Empfangsteil der Sende-Empfangseinrichtung trifft. Der tatsächliche Ort des Fokus hängt von der Stellung des Optikelements ab und liegt vorzugsweise in unmittelbarer Nähe des Empfangsteils beziehungsweise in dem Empfangsteil.

Darüber hinaus besitzt die Bedienvorrichtung eine Auswerteeinrichtung zum Auswerten eines Signals des Empfangsteils, wobei die Auswerteeinrichtung derart ausgebildet ist, dass einer Intensität des empfangenen Lichts, die durch das Signal repräsentiert wird, eine Stellung des Bedienelements in einem Bereich von der ersten Extremstellung zu der zweiten Extremstellung zugeordnet wird. Es wird also in Abhängigkeit von dem empfangenen optischen Signal auf die Stellung beziehungsweise Position des Bedienelements geschlossen. Da sich das Bedienelement von der ersten Extremstellung zur zweiten Extremstellung beziehungsweise umgekehrt bewegen kann, ändert sich entsprechend auch die Lichtintensität des Lichts, welches in Richtung auf das Empfangsteil fokussiert ist. Entsprechend der Bewegung ändert sich der Fokus des Lichts und damit auch an der Stelle des Empfangsteils die Intensität des Lichts. Auf diese Weise kann sehr genau auf die Position des Bedienelements geschlossen werden. Insbesondere kann nicht nur die jeweilige Extremstellung zweifelsfrei erkannt werden, sondern in Abhängigkeit von der Intensitätsänderung des Lichts auch entsprechende Zwischenstellungen je nach Auflösung.

Vorzugsweise wird das Optikelement durch einen konkaven Abschnitt des Bedienelements gebildet. Das Bedienelement besitzt also einen konkaven Abschnitt, der günstigerweise unmittelbar in das Bedienelement eingearbeitet ist. Der konkave Abschnitt kann aber auch durch ein separates Element gebildet werden, das an dem Bedienelement fixiert ist. Der konkave Abschnitt besitzt die optische Eigenschaft, Licht zu bündeln beziehungsweise zu fokussieren. Vorzugsweise ist der konkave Abschnitt hinsichtlich seiner Oberflächengeometrie derart optimiert, dass sich eine hochwertige Fokussierung ergibt. Damit erfüllt das Bedienelement eine doppelte Funktionalität, nämlich die des Betätigtwerdens, aber auch die des Umlenkens beziehungsweise Fokussierens des Lichts der Sende-Empfangseinrichtung.

In einer weiteren Ausgestaltung kann vorgesehen sein, dass ein jeweiliger Brennpunkt des Lichts in jeder der beiden Extremstellungen des Bedienelements außerhalb der Sende-Empfangseinrichtung liegt. Dabei ist vorzuziehen, dass der Brennpunkt des Lichts bezüglich des Empfangsteils der Sende-Empfangseinrichtung immer auf einer Seite liegt. Wenn andernfalls der Fokus nämlich bei seiner Wanderung, die sich aus der Bewegung des Bedienelements beziehungsweise Optikelements von der ersten Extremstellung in die zweite Extremstellung ergibt, das Empfangsteil durchkreuzt oder von einer Seite des Empfangsteils zur anderen Seite gelangt, ist die Auswertung der Intensität nicht mehr eindeutig auf die Stellung des Bedienelements zu beziehen. Daher sollte der Brennpunkt günstigerweise bei seiner Bewegung nicht den Empfangsteil durchlaufen und dabei ein Intensitätsmaximum liefern. Vielmehr ist bei der Bewegung des Bedienelements beziehungsweise des Brennpunkts wünschenswert, wenn die Intensität stetig zu- oder abnimmt.

In einer alternativen Ausführungsform kann vorgesehen sein, dass ein jeweiliger Brennpunkt des Lichts in jeder der beiden Extremstellungen des Bedienelements innerhalb der Sende-Empfangseinrichtung liegt. Wenn der jeweilige Brennpunkt stets innerhalb der Sende-Empfangseinrichtung liegt, befindet er sich stets sehr nahe an dem Empfangsteil der Sende-Empfangseinrichtung. Diese bedeutet, dass eine gute Fokussierung vorliegt und daher mit einem entsprechend hohen Intensitätssignal in jeder Stellung des Bedienelements zu rechnen ist.

In einer weiteren Ausgestaltung kann vorgesehen sein, dass das Optikelement derart gestaltet ist und das von der Sende-Empfangseinrichtung ausgesandte Licht derart auf das Optikelement gerichtet ist, dass sich ein Brennpunkt bei einem Bewegen des Bedienelements in einer Betätigungsrichtung mit einer Bewegungskomponente parallel zu dieser Betätigungsrichtung bewegt. Dies bedeutet beispielsweise, wenn das Betätigungselement senkrecht nach unten bewegt wird, dann wandert mit dieser Bewegung auch der Brennpunkt senkrecht nach unten. Der Brennpunkt muss sich aber nicht zwangsläufig in der gleichen Richtung beziehungsweise parallel zu der Betätigungsrichtung bewegen. Vielmehr genügt es, wenn von der Bewegungsrichtung des Brennpunkts zumindest eine Komponente (d.h. Vektorkomponente) parallel zu Betätigungsrichtung verläuft. D.h. bei einer Betätigungsrichtung senkrecht nach unten kann sich der Brennpunkt auch schräg nach unten bewegen.

Erfindungsgemäß ist vorgesehen, dass das Optikelement derart asymmetrisch gestaltet und das von der Sende-Empfangseinrichtung ausgesandte Licht derart auf das Optikelement gerichtet ist, dass sich ein Brennpunkt bei einem Bewegen des Bedienelements in einer Betätigungsrichtung mit einer Bewegungskomponente senkrecht zu dieser Betätigungsrichtung bewegt. In diesem Fall kann sich der Brennpunkt beispielsweise ausschließlich senkrecht zu der Betätigungsrichtung des Bedienelements bewegen. In der Regel wird es aber so sein, dass sich der Brennpunkt nicht nur senkrecht zu der Betätigungsrichtung bewegt, sondern auch mit einer Teilkomponente in Richtung der Betätigungsrichtung. Damit ergäbe sich wieder eine schräge Bewegung des Brennpunkts in Bezug auf die Bewegung des Bedienelements. Eine derartige Bewegungskomponente senkrecht zu der Betätigungsrichtung kann erfindungsgemäß dadurch erreicht werden, dass das Optikelement asymmetrisch gestaltet ist. Beispielsweise kann das Optikelement die Negativform eines halben Tropfens besitzen. Gleichzeitig ist es dabei von Vorteil, wenn das Optikelement asymmetrisch bezüglich der Hauptabstrahlrichtung des Sendeteils der Sende-Empfangseinrichtung angeordnet ist. Beispielsweise kann sich der Brennpunkt in einer ersten Extremstellung des Bedienelements innerhalb des Empfangsteils und in der zweiten Extremstellung des Bedienelements außerhalb des Empfangsteils der Sende-Empfangseinrichtung befinden. Durch dieses Wandern des Brennpunkts senkrecht zu der Betätigungsrichtung kann eine sehr hohe Ortsauflösung erreicht werden.

Vorzugsweise handelt es sich bei dem Optikelement um einen Reflektor. Mit einem solchen Reflektor ist es einfacher realisierbar, das von dem Sendeteil der Sende-Empfangseinrichtung ausgesandte Licht auf das Empfangsteil zu reflektieren. Wenn Sende- und Empfangsteil beispielsweise auf einem Chip sehr nahe beieinander liegen, wird das Licht durch den Reflektor praktisch zurück reflektiert. Es handelt sich dann praktisch um eine Bedienvorrichtung mit Reflexionslichtschranke, wobei der Reflektor bewegbar ist.

In einer weiteren Ausgestaltung weist die Sende-Empfangseinrichtung an einer Seite gemeinsam ein Sendeteil zum Aussenden des Lichts und das Empfangsteil zum Empfangen des Lichts auf. Dies bedeutet, dass sowohl Sendeteil als auch Empfangsteil bei einer beispielsweise quaderförmigen Sende-Empfangseinrichtung sich auf ein und derselben Seite der Sende-Empfangseinrichtung befinden. Insbesondere ist dies bei sogenannten Einchiplösungen vorteilhaft. Sowohl Sendeteil als auch Empfangsteil sind dabei vorteilhaft direkt auf das Optikelement beziehungsweise das Bedienelement gerichtet.

Ein weiteres Ausführungsbeispiel einer Bedienvorrichtung kann dahingehend gestaltet sein, dass die Auswerteeinrichtung dazu ausgebildet ist, das Signal des Empfangsteils zwei vorgegebenen Stellungen des Bedienelements binär zuzuordnen. Vorzugsweise handelt es sich bei den zwei vorgegebenen Stellungen um die beiden Extremstellungen. Auf diese Weise kann ein sicherer Ein-/Ausschalter realisiert werden.

Des Weiteren kann vorgesehen sein, dass die Auswerteeinrichtung dazu ausgebildet ist, das Signal des Empfangsteils kontinuierlich einer jeweiligen Stellung des Bedienelements in dem Bereich von der ersten Extremstellung zu der zweiten Extremstellung zuzuordnen. Damit lässt sich nicht nur ein binärer Schalter realisieren, sondern eine kontinuierliche Einstellung vornehmen. Beispielsweise ist eine derartige kontinuierliche Einstellung für eine Beleuchtung oder einen Fensterheber im Kraftfahrzeug von Vorteil.

Wie oben bereits angedeutet wurde, kann eine Fahrzeugbedienanordnung mit der oben beschriebenen Bedienvorrichtung ausgestattet sein. Es lässt sich damit eine Fahrzeugbedienanordnung realisieren, die optisch zuverlässig auswertbar ist. Insbesondere ergibt sich dabei eine hohe Störsicherheit. Darüber hinaus kann gegebenenfalls auch eine hohe Auflösung für die Fahrzeugbedienanordnung erreicht werden.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen. Es sind darüber hinaus Ausführungen und Merkmalskombinationen, insbesondere durch die oben dargelegten Ausführungen, als offenbart anzusehen, die über die in den Rückbezügen der Ansprüche dargelegten Merkmalskombinationen hinausgehen oder von diesen abweichen.

Die vorliegende Erfindung wird nun anhand der beigefügten Zeichnungen näher erläutert, in denen zeigen:
Fig. 1 eine Bedienvorrichtung gemäß einem ersten Beispiel in einem unbetätigten Zustand;
Fig. 2 die Bedienvorrichtung von Fig. 1 im betätigten Zustand;
Fig. 3 eine Bedienvorrichtung gemäß einem zweiten Beispiel im unbetätigten Zustand;
Fig. 4 die Bedienvorrichtung von Fig. 3 im betätigten Zustand;
Fig. 5 eine Bedienvorrichtung gemäß einem Ausführungsbeispiel der Erfindung im unbetätigten Zustand; und
Fig. 6 die Bedienvorrichtung von Fig. 5 im betätigten Zustand.

Wie eingangs erwähnt wurde, ist bekannt, die Änderung der Entfernung eines Reflektors mithilfe optischer Reflexionslichtschranken zu bestimmen. Die Auflösung der Änderung der Entfernung ist bei diesem Prinzip nur grob. Für die Erkennung eines geschalteten Zustands oder einer Krafterkennung bei Schaltern ist jedoch eine höhere Auflösung notwendig. Hierzu ist die vorliegende Erfindung hilfreich.

Die Erfindung basiert auf der Idee, dass eine Fokussierung von ausgesandtem Licht abhängig von einer Position eines Reflektors eine große Änderung der Lichtmenge auf einem Sensor hervorruft. Dabei kann es sinnvoll sein, die Geometrie einer zumindest teilweise spiegelnden Oberfläche eines Reflektors entsprechend auszugestalten. Der Brennpunkt kann beispielsweise in verschiedene Richtungen wandern (horizontal und/oder vertikal). Damit erreicht man eine höhere Auflösung bei gegebener Wegänderung.

Beispielsweise kann bei einer Bedienvorrichtung mit einem Bedienelement und einer Grundplatte ersteres relativ zu zweiterer bewegt werden. Die Betätigung wird über die entsprechende Abstandsänderung detektiert, wobei die Detektion über einen optischen Sensor mit Sender und Empfänger erfolgt. Der optische Sensor ist in diesem Beispiel an der Grundplatte angebracht und sendet Licht in Richtung der Bedienoberfläche aus, an welcher das Licht zum Empfänger des Sensors zurückreflektiert wird. Dazu ist das Bedienelement derart gestaltet, dass der Brennpunkt des zurückreflektierten Lichts bei Null-Stellung oder Betätigungsstellung im Bereich des Empfängers liegt. Der Abstand des Brennpunkts von dem Empfangsteil sollte nicht größer sein als des Empfangsteil selbst.

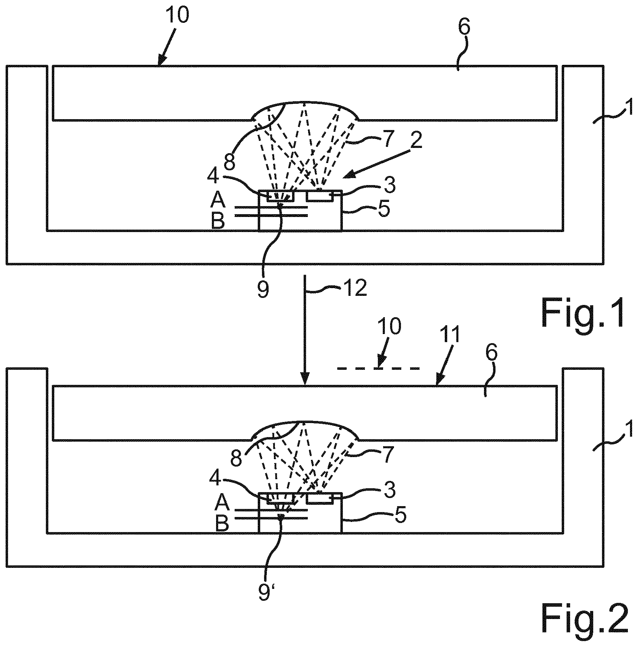

Fig. 1 zeigt ein erstes Beispiel einer Bedienvorrichtung. Die Bedienvorrichtung weist in dem vorliegenden Beispiel ein Gehäuse auf, das ein Grundelement 1 bildet. Ein alternatives Grundelement 1 könnte eine einfache Grundplatte sein. Das Gehäuse beziehungsweise Grundelement 1 dient als Träger für eine Sende-Empfangseinrichtung 2. Diese ist fest mit dem Grundelement 1 verbunden. Die Sende-Empfangseinrichtung 2 besitzt ein Sendeteil 3 und ein Empfangsteil 4. Beispielsweise sind das Sendeteil 3 und das Empfangsteil 4 gemeinsam in einem Sensorgehäuse 5 der Sende-Empfangseinrichtung 2 untergebracht.

Weiterhin besitzt die Bedienvorrichtung ein Bedienelement 6. Dieses Bedienelement 6 ist beispielsweise ein Tastelement, welches mit dem Finger herabgedrückt werden kann. Das Bedienelement 6 ist also relativ zu dem Grundelement 1 bewegbar. Dazu besitzt das Grundelement 1 beziehungsweise das Bedienelement 6 beispielsweise eine entsprechende Linearführung. Diese kann durch Wände des Gehäuses beziehungsweise Grundelements 1 realisiert sein. Fig. 1 zeigt das Bedienelement 6 gegenüber dem Grundelement 1 in einer ersten Extremstellung, hier insbesondere in einer Stellung, in der das Bedienelement 6 von dem Grundelement 1 am weitesten entfernt ist.

Die Sende-Empfangseinrichtung 2 mit einer in den Fig. nicht näher dargestellten Auswerteeinrichtung, die ebenfalls in das Sensorgehäuse 5 integriert sein kann, wird die Position beziehungsweise Stellung des Bedienelements 6 relativ zu dem Grundelement 1 beziehungsweise der Sende-Empfangseinrichtung 2 bestimmen. Dies geschieht dadurch, dass das Sendeteil 3 der Sende-Empfangseinrichtung 2 Licht 7 aussendet, welches von dem Bedienelement 6 in Richtung auf das Empfangsteil 4 umgelenkt und fokussiert wird. Dazu besitzt das Bedienelement 6 ein Optikelement 8, welches im vorliegenden Beispiel als konkaver, symmetrischer Reflektor ausgebildet ist. Das Optikelement 8 ist hier unmittelbar in das Bedienelement 6 integriert. Alternativ könnte das Optikelement 8 auch auf dem Bedienelement 6 als eigenes Element befestigt sein.

In dem Beispiel von Fig. 1 wird das Licht des Sendeteils 3 derart auf das Optikelement 8 gestrahlt und gleichzeitig ist das Optikelement 8 derart gestaltet (insbesondere geometrisch), dass das Licht 7 in einer Ebene A fokussiert wird. Es bildet sich ein entsprechender Brennpunkt 9. Dieser liegt hier innerhalb der Sende-Empfangseinrichtung 2 und insbesondere knapp unter dem Empfangsteil 4.

Wird nun gemäß Fig. 2 das Bedienelement 6 entsprechend einer Betätigungsrichtung 10 auf das Grundelement 1 zu bewegt, so verändert sich seine relative Stellung gegenüber dem Grundelement 1. In Fig. 1 nimmt das Bedienelement 6 eine erste Extremstellung 10 ein, was hier der Nicht-Betätigungsstellung der Bedienvorrichtung entspricht. In Fig. 2 hingegen nimmt das Bedienelement 6 eine zweite Extremstellung 11 ein, die einer Betätigungsstellung entspricht. Das Bedienelement 6 lässt sich nur zwischen diesen beiden Extremstellungen 10 und 11 bewegen. Damit die Extremstellungen 10 und 11 nicht überschritten werden, sind entsprechende Anschläge vorgesehen, die in den Fig. nicht dargestellt sind. In der zweiten Extremstellung 11 wirkt beispielsweise durch einen Finger eine Kraft 12 in Betätigungsrichtung. Aufgrund der Bewegung des Bedienelements in die zweite Extremstellung 11 wandert auch der Fokus 9 von der Ebene A in die Ebene B. Diese Ebene B, die parallel zu der Ebene A verläuft und darüber hinaus senkrecht zu der Betätigungsrichtung beziehungsweise der Kraft 12 ausgerichtet ist, liegt näher an dem Boden 13 des Grundelements 1 als die Ebene A. Gleichzeitig liegt die Ebene B weiter von dem Empfangsteil 4 entfernt als die Ebene A. Aufgrund der zweiten Extremstellung 11 des Bedienelements 6 beziehungsweise des Optikelements 8 ergibt sich demzufolge ein neuer Fokus 9' auf der Ebene B. Auch dieser neue Fokus 9' liegt innerhalb der Sende-Empfangseinrichtung 2 direkt unterhalb des Empfangsteils 4.

Es ist sofort zu erkennen, dass die Lichtintensität in der ersten Extremstellung 10 des Bedienelements 6 gemäß Fig. 1 auf beziehungsweise im Empfangsteil 4 größer ist als die Intensität des Lichts 7 in der zweiten Extremstellung 11 gemäß Fig. 2. Dies liegt daran, dass der Fokus 9 in der ersten Extremstellung 10 näher an dem Empfangsteil 4 liegt als der Fokus 9' in der zweiten Extremstellung 11. Aufgrund dieses Intensitätsunterschieds kann die Auswerteeinrichtung sofort entscheiden, in welcher Stellung sich das Bedienelement 6 befindet. Gegebenenfalls kann sogar der Weg zwischen den beiden Extremstellungen 10 und 11 aufgrund der Intensitätsabnahme festgestellt werden.

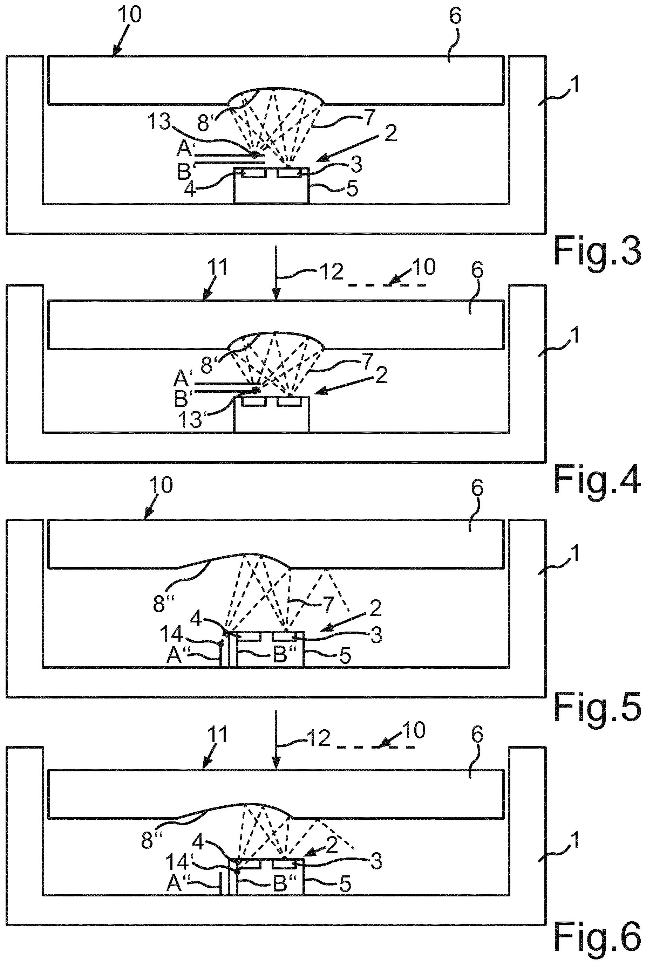

In den Fig. 3 und 4 ist ein zweites Beispiel einer Bedienvorrichtung schematisch wiedergegeben. Die einzelnen Komponenten entsprechen in ihrer Art, in ihrem Aufbau und in ihrer Funktionsweise im Wesentlichen denen der ersten Ausführungsform gemäß den Fig. 1 und 2. Es ist lediglich das Optikelement 8' beziehungsweise die Abstrahlung des Lichts 7 von Sendeteil 3 derart gerichtet beziehungsweise gebündelt, dass sich in der Nähe des Empfangsteils 4 ein Fokus 13 in einer Ebene A' bildet. Die Ebene A' befindet sich außerhalb der Sende-Empfangseinrichtung 2 und insbesondere oberhalb des Empfangsteils 4, also zwischen Empfangsteil 4 und Bedienelement 6. Dies gilt für die erste Extremstellung 10.

In der zweiten Extremstellung 11 gemäß Fig. 4, in der das Bedienelement 6 mit einer Kraft 12 in gleichgerichteter Betätigungsrichtung bewegt ist, ergibt sich ein Fokus 13' in einer Ebene B'. Diese Ebene B', die parallel zu der Ebene A' verläuft, steht wiederum senkrecht auf der Betätigungsrichtung beziehungsweise der Kraft 12. Der Brennpunkt 13' liegt ebenfalls außerhalb der Sende-Empfangseinrichtung 2 und insbesondere oberhalb des Empfangsteils 4. Er befindet sich also auch zwischen der Sende-Empfangseinrichtung 2 und dem Bedienelement 6. Der Fokus 13 wandet in Betätigungsrichtung auf den Fokus 13', wenn das Bedienelement 6 von der ersten Extremstellung 10 in die zweite Extremstellung 11 bewegt wird.

In diesem Fall ist zu erkennen, dass das Licht 7 umgelenkt durch das Optikelement 8' dann eine höhere Intensität besitzt, wenn sich das Bedienelement 6 in der zweiten Extremstellung befindet und damit der Brennpunkt 13' näher an dem Empfangsteil 4 liegt als der Brennpunkt 13 bei der ersten Extremstellung 10. Auch hier kann die Auswerteeinrichtung die Stellung des Bedienelements 6 relativ zu dem Grundelement 1 klar von der Intensität des auf das Empfangsteil 4 einfallenden Lichts ableiten.

Die Fig. 5 und 6 zeigen ein Ausführungsbeispiel der erfindungsgemäßen Bedienvorrichtung. Wiederum ist der Aufbau der Bedienvorrichtung im Wesentlichen gleich demjenigen der Bedienvorrichtung gemäß den Fig. 1 und 2. Hier ist allerdings das Optikelement 8" in beziehungsweise an dem Bedienelement 6 bezüglich der in den Fig. 5 und 6 dargestellten Schnittebene asymmetrisch ausgebildet. Das Optikelement 8" ist zwar auch hier konkav und fokussierend ausgebildet, aber durch dessen Asymmetrie bewegt sich der Brennpunkt senkrecht zu der Betätigungsrichtung des Bedienelements 6 beziehungsweise der darauf ausgeübten Kraft 12. Konkret befindet sich ein Fokus 14 des von dem Optikelement 8" umgelenkten und fokussierten Lichts 7 in einer Ebene A", wenn sich das Bedienelement 6 in der ersten Extremstellung 10 (Nicht-Betätigungsstellung) befindet. Die Ebene A" verläuft hier parallel zu der vorgegebenen Betätigungsrichtung des Bedienelements 6, hier parallel zur Kraft 12. Außerdem liegt die Ebene A" außerhalb der Sende-Empfangseinrichtung 2.

Wird nun die Bedienvorrichtung mit einer Kraft 12 in selbiger Richtung betätigt, so verschiebt sich der Fokus auf den neuen Brennpunkt 14', der in Ebene B" liegt. Die Ebene B" ist parallel zu der Ebene A" und ebenfalls parallel zu der Kraft 12 beziehungsweise Betätigungsrichtung. Ferner liegt der Brennpunkt 14' hier innerhalb der Sende-Empfangseinrichtung 2.

Es ist zu erkennen, dass der Brennpunkt 14' näher an dem Empfangsteil 4 liegt als der Brennpunkt 14. Demzufolge ist auch die Lichtintensität an beziehungsweise in dem Empfangsteil 4 höher, wenn sich das Bedienelement 6 in der zweiten Extremstellung 11 befindet gegenüber dem Fall, dass sich das Bedienelement 6 in der ersten Extremstellung 10 und der Brennpunkt 14 entsprechend außerhalb der Sende-Empfangseinrichtung 2 befindet. In diesem Beispiel wird also eine Betätigung des Bedienelements 6 in eine dazu senkrechte Verschiebung des Brennpunkts umgesetzt. Trotzdem lässt sich auch hier die Stellung des Bedienelements 6 eindeutig an der jeweiligen Intensität des Lichts an dem Empfangsteil erkennen. Ähnliches gilt, wenn sich bei Betätigung des Bedienelements 6 der Brennpunkt schräg zu der Betätigungsrichtung verschiebt. Für eine eindeutige Zuordnung der Intensität zu einer Stellung des Bedienelements ist es allgemein von Vorteil, wenn der Brennpunkt in einer Extremstellung des Bedienelements näher an dem Empfangsteil 4 liegt als in der zweiten Extremstellung des Bedienelements. Nachteilig wäre, wenn der Brennpunkt das Empfangsteil 4 durchwandert, wenn sich das Bedienelement 6 von der einen Extremstellung 10 in die andere Extremstellung 11 bewegt. In diesem Fall könnte das Bedienelement 6 bei gleicher Lichtintensität zwei verschiedene Stellungen einnehmen. Im Extremfall könnte also allenfalls der Brennpunkt in einer der beiden Extremstellungen in beziehungsweise auf dem Empfangsteil 4 liegen, damit die Position des Bedienelements 6 noch eindeutig bestimmt werden kann. Aus Toleranzgründen ist es aber vorzuziehen, dass der Brennpunkt stets außerhalb des Empfangsteils 4 liegt.

## Patentansprüche

1. Bedienvorrichtung mit
- einem Grundelement (1),
- einer Sende-Empfangseinrichtung, die fest an dem Grundelement (1) angeordnet ist, zum Aussenden und Empfangen von Licht (7),
- einem Bedienelement (6), das gegenüber dem Grundelement (1) zwischen einer ersten Extremstellung (10) und einer zweiten Extremstellung (11) bewegbar ist, und
- einem Optikelement (8), das fest an dem Bedienelement (6) angeordnet ist, zum Umlenken des Lichts (7) der Sende-Empfangseinrichtung,
wobei
- durch das Optikelement (8) das Licht (7) der Sende-Empfangseinrichtung im Wesentlichen in Richtung auf ein Empfangsteil (4) der Sende-Empfangseinrichtung fokussierbar ist und
- eine Auswerteeinrichtung der Bedienvorrichtung zum Auswerten eines Signals des Empfangsteils (4) derart ausgebildet ist, dass eine Intensität des empfangenen Lichts (7), die durch das Signal repräsentiert wird, einer Stellung des Bedienelements (6) in einem Bereich von der ersten Extremstellung (10) bis zu der zweiten Extremstellung (11) zugeordnet wird, **dadurch gekennzeichnet, dass**
- das Optikelement (8) derart asymmetrisch gestaltet und das von der Sende-Empfangseinrichtung ausgesandte Licht (7) derart auf das Optikelement (8) gerichtet ist, dass sich ein Brennpunkt (14) bei einem Bewegen des Bedienelements (6) in einer Betätigungsrichtung (12) mit einer Bewegungskomponente senkrecht zu dieser Betätigungsrichtung (12) bewegt.

2. Bedienvorrichtung nach Anspruch 1,
**dadurch gekennzeichnet, dass**
das Optikelement (8) durch einen konkaven Abschnitt des Bedienelements (6) gebildet ist.

3. Bedienvorrichtung nach Anspruch 1 oder 2,
**dadurch gekennzeichnet, dass**
ein jeweiliger Brennpunkt (14) des Lichts (7) in jeder der beiden Extremstellungen (10, 11) des Bedienelements (6) außerhalb des Empfangsteils (4) der Sende-Empfangseinrichtung liegt.

4. Bedienvorrichtung nach Anspruch 1 oder 2,
**dadurch gekennzeichnet, dass**
ein jeweiliger Brennpunkt (14) des Lichts (7) in jeder der beiden Extremstellungen (10, 11) des Bedienelements (6) innerhalb der Sende-Empfangseinrichtung liegt.

5. Bedienvorrichtung nach einem der vorhergehenden Ansprüche, **dadurch gekennzeichnet, dass**
das Optikelement (8) einen Reflektor aufweist.

6. Bedienvorrichtung nach einem der vorhergehenden Ansprüche, **dadurch gekennzeichnet, dass**
die Sende-Empfangseinrichtung an einer Seite gemeinsam ein Sendeteil (3) zum Aussenden des Lichts (7) und das Empfangsteil (4) zum Empfangen des Lichts (7) aufweist.

7. Bedienvorrichtung nach einem der vorhergehenden Ansprüche, **dadurch gekennzeichnet, dass**
die Auswerteeinrichtung dazu ausgebildet ist, das Signal des Empfangsteils (4) zwei vorgegebenen Stellungen des Bedienelements (6) binär zuzuordnen.

8. Bedienvorrichtung nach einem der Ansprüche 1 bis 6, **dadurch gekennzeichnet, dass**
die Auswerteeinrichtung dazu ausgebildet ist, das Signal des Empfangsteils (4) kontinuierlich einer jeweiligen Stellung des Bedienelements (6) in dem Bereich von der ersten Extremstellung (10) zu der zweiten Extremstellung (11) zuzuordnen.

9. Fahrzeugbedienanordnung mit einer Bedienvorrichtung nach einem der vorhergehenden Ansprüche.

## Claims

1. Operating device having
- a base element (1),
- a transceiver, which is arranged fixedly on the base element (1), for emitting and receiving light (7),
- an operating element (6), which is movable with respect to the base element (1) between a first extreme position (10) and a second extreme position (11), and
- an optical element (8) which is arranged fixedly at the operating element (6), for deflecting the light (7) of the transceiver,
wherein
- the light (7) of the transceiver is focusable substantially towards a receiving part (4) of the transceiver by the optical element (8) and
- an evaluation apparatus of the operating device, for evaluating a signal of the receiving part (4), is formed in such a way that an intensity of the received light (7), which is represented by the signal, is assigned to a position of the operating element (6) in a range from the first extreme position (10) to the second extreme position (11),
**characterized in that**
- the optical element (8) is designed asymmetrically in such a way and the light (7) emitted by the transceiver is directed to the optical element (8) in such a way that, when the operating element (6) moves in an actuating direction (12), a focal point (14) moves with a movement component perpendicular to this actuating direction (12).

2. Operating device according to Claim 1,
**characterized in that**
the optical element (8) is formed by a concave section of the operating element (6).

3. Operating device according to Claim 1 or 2,
**characterized in that**
a respective focal point (14) of the light (7) in each of the two extreme positions (10, 11) of the operating element (6) is located outside the receiving part (4) of the transceiver.

4. Operating device according to Claim 1 or 2,
**characterized in that**
a respective focal point (14) of the light (7) in each of the two extreme positions (10, 11) of the operating element (6) is located inside the transceiver.

5. Operating device according to any of the preceding claims,
**characterized in that**
the optical element (8) comprises a reflector.

6. Operating device according to any of the preceding claims,
**characterized in that**
the transceiver has both a transmitting part (3) for emitting the light (7) and the receiving part (4) for receiving the light (7) at one side.

7. Operating device according to any of the preceding claims,
**characterized in that**
the evaluation apparatus is formed to assign the signal of the receiving part (4) to two specified positions of the operating element (6) in binary fashion.

8. Operating device according to any of Claims 1 to 6,
**characterized in that**
the evaluation apparatus is formed to assign the signal of the receiving part (4) continuously to a respective position of the operating element (6) in the range from the first extreme position (10) to the second extreme position (11).

9. Vehicle operating arrangement having an operating device according to any of the preceding claims.

## Revendications

1. Arrangement de commande comprenant
- un élément de base (1),
- un dispositif d'émission-réception, qui est monté à demeure sur l'élément de base (1), destiné à émettre et à recevoir de la lumière (7),
- un élément de commande (6), qui peut être déplacé par rapport à l'élément de base (1) entre une première position extrême (10) et une deuxième position extrême (11), et
- un élément optique (8), qui est monté à demeure sur l'élément de commande (6), destiné à dévier la lumière (7) du dispositif d'émission-réception,
- la lumière (7) du dispositif d'émission-réception pouvant être focalisée par l'élément optique (8) sensiblement en direction d'une partie de réception (4) du dispositif d'émission-réception et
- un dispositif d'interprétation de l'arrangement de commande destiné à interpréter un signal de la partie de réception (4) étant configuré de telle sorte qu'une intensité de la lumière (7) reçue, qui est représentée par le signal, est associée à une position de l'élément de commande (6) dans une plage entre la première position extrême (10) et la deuxième position extrême (11), **caractérisé en ce que**
- l'élément optique (8) est configuré de manière asymétrique et la lumière (7) émise par le dispositif d'émission-réception est dirigée sur l'élément optique (8) de telle sorte qu'un point focal (14), lors d'un mouvement de l'élément de commande (6) dans une direction d'actionnement (12), se déplace avec une composante de mouvement perpendiculaire à cette direction d'actionnement (12).

2. Arrangement de commande selon la revendication 1, **caractérisé en ce que** l'élément optique (8) est formé par une portion concave de l'élément de commande (6).

3. Arrangement de commande selon la revendication 1 ou 2, **caractérisé en ce qu'**un point focal (14) respectif de la lumière (7) dans chacune des deux positions extrêmes (10, 11) de l'élément de commande (6) se trouve en-dehors de la partie de réception (4) du dispositif d'émission-réception.

4. Arrangement de commande selon la revendication 1 ou 2, **caractérisé en ce qu'**un point focal (14) respectif de la lumière (7) dans chacune des deux positions extrêmes (10, 11) de l'élément de commande (6) se trouve à l'intérieur du dispositif d'émission-réception.

5. Arrangement de commande selon l'une des revendications précédentes, **caractérisé en ce que** l'élément optique (8) possède un réflecteur.

6. Arrangement de commande selon l'une des revendications précédentes, **caractérisé en ce que** le dispositif d'émission-réception possède, sur un côté en commun, une partie d'émission (3) destinée à émettre la lumière (7) et la partie de réception (4) destinée à recevoir la lumière (7).

7. Arrangement de commande selon l'une des revendications précédentes, **caractérisé en ce que** le dispositif d'interprétation est configuré pour associer de manière binaire le signal de la partie de réception (4) à deux positions prédéfinies de l'élément de commande (6).

8. Arrangement de commande selon l'une des revendications précédentes 1 à 6, **caractérisé en ce que** le dispositif d'interprétation est configuré pour associer continuellement le signal de la partie de réception (4) à une position respective de l'élément de commande (6) dans la zone de la première position extrême (10) à la deuxième position extrême (11).

9. Système de commande de véhicule comprenant un arrangement de commande selon l'une des revendications précédentes.
